Europäisches Patentamt

(19) European Patent Office

Office européen des brevets

(11) Numéro de publication: **0 068 950**

**B1**

(12) **FASCICULE DE BREVET EUROPÉEN**

(51) Int. Cl.⁴: **C 23 C 16/06**, C 23 C 16/08

(45) Date de publication du fascicule du brevet:
04.11.87

(21) Numéro de dépôt: **82401044.1**

(22) Date de dépôt: **09.06.82**

(54) Procédé, en phase vapeur, pour le dépôt d'un revêtement protecteur sur une pièce métallique, dispositif pour sa mise en oeuvre et pièces obtenues selon ledit procédé.

(30) Priorité: **18.06.81 FR 8111988**

(43) Date de publication de la demande:
**05.01.83 Bulletin 83/1**

(45) Mention de la délivrance du brevet:
**04.11.87 Bulletin 87/45**

(84) Etats contractants désignés:
**CH DE FR GB LI**

(56) Documents cité:
**FR-A-1 142 013**
**FR-A-2 303 089**
**FR-A-2 378 873**
**GB-A-827 132**
**US-A-3 286 684**

(73) Titulaire: **SOCIETE NATIONALE D'ETUDE ET DE CONSTRUCTION DE MOTEURS D'AVIATION, "S.N.E.C.M.A.", 2 Boulevard Victor, F-75015 Paris (FR)**

(72) Inventeur: **Gauje, Georges Maurice Célestin A., 25, Chemin de la grille au Roi, F-91160 Saulx les Chartreux Longjumeau (FR)**

(74) Mandataire: **Moinat, François, S.N.E.C.M.A. Service des Brevets Boîte Postale 81, F-91003 Evry Cedex (FR)**

## Description

La présente invention concerne un procédé, en phase vapeur, pour le dépôt d'un revêtement protecteur sur une pièce métallique ou un ensemble de pièces; elle concerne également les dispositifs pour la mise en oeuvre de ce procédé et les pièces obtenues selon ledit procédé.

On a déjà décrit dans le brevet français 1 433 497 un procédé pour la protection des pièces métalliques, notamment des pièces en alliage réfractaire présentant, à haute température, une résistance élevée à la déformation vis-à-vis d'efforts d'origine mécanique et thermique, par revêtement de la surface desdites pièces par un métal convenable, ledit procédé consistant à mettre en contact lesdites pièces métalliques, situées dans une enceinte convenablement chauffée, avec un halogénure du métal à déposer sur la surface desdites pièces, ledit halogénure, gazeux à la température de ladite enceinte, étant formé par réaction à haute température d'un composé chimique halogéné sur un dérivé (métal ou alliage ou produit chimique) du métal à déposer qui est par exemple l'aluminium.

Des modes d'application de cette technique générale ont été notamment décrits dans les brevets français 2 134 220 et 2 181 512 pour les revêtements en carbure, nitrure ou carbonitrure de titane.

GB-A-827 132 décrit également un procédé en phase vapeur pour le dépôt d'un revêtement projecteur sur une pièce métallique située dans une enceinte chauffée par réaction avec un halogénure d'un métal à déposer sans contact solide-solide.

Par ailleurs, FR-A-2 378 873 décrit un procédé en phase vapeur pour un dépôt de revêtement adapté aux semi-conducteurs, obtenu à partir d'un donneur sous forme de poudres, par réaction chimique en présence d'un agent porteur et transfert utilisant une pièce intermédiaire.

Dans le brevet de base 1 433 497 et dans les modes d'application décrits dans les brevets 2 134 220 et 2 181 512 le "donneur", c'est-à-dire le dérivé du métal à déposer, a été utilisé sous forme de particules, c'est-à-dire de grains plus ou moins gros, que l'on disposait avantageusement dans des paniers situés dans l'enceinte chauffée où s'effectue le revêtement.

Or, on s'est aperçu que la forme sous laquelle le donneur était utilisé pouvait avoir une influence certaine non seulement sur les facilités de mise en oeuvre du procédé tel que décrit mais encore sur les résultats que l'on pouvait obtenir.

On a trouvé, et c'est là l'objet de la présente invention, que dans le procédé décrit dans les brevets mentionnés ci-dessus il était tout à fait avantageux d'utiliser un donneur ayant la forme de tôle, c'est-à-dire d'un objet en métal ou alliage du métal à déposer, mince et dont la surface est du même ordre de grandeur que celle de la pièce (ou de l'ensemble des pièces) à revêtir qui se trouve face à ladite tôle.

L'invention a donc pour objet un procédé tel que défini dans la revendication 1. Des modes de réalisation préférés font l'objet des revendications dépendantes.

La tôle utilisée selon l'invention doit être mince de façon à présenter une inertie thermique relativement faible et diminuer autant que possible la durée nécessaire pour la mise en équilibre thermique de tous les éléments situés dans l'enceinte.

La tôle utilisée doit avoir une surface du même ordre de grandeur que la portion de surface de la pièce à revêtir qui se trouve en face de ladite tôle. De cette façon en effet le métal donneur peut donner naissance assez rapidement à une quantité suffisante d'halogénure pour assurer un revêtement rapide de la totalité de la surface de la pièce à revêtir et de plus la quantité d'halogenure formée est sensiblement la même en tous les points de l'espace situés à proximité de la surface à revêtir. Cette dernière propriété est spécialement intéressante dans la mesure où les pièces à revêtir ont des formes compliquées et tourmentées car on peut adapter la forme de la "tôle donneuse" à la forme locale et/ou d'ensemble de la pièce à revêtir.

Un autre avantage de l'utilisation d'un donneur sous forme de tôle est d'éviter les phénomènes de collages divers auxquels on se heurte lorsqu'on utilise le donneur sous forme de grains.

Par suite, un procédé, en phase vapeur, pour le dépôt d'au moins un revêtement protecteur sur une pièce métallique ou un ensemble de pièces, du genre précité est caractérisé en ce que le donneur se présente sous forme d'une tôle mince disposée de manière à ce que chacune des surfaces à revêtir soit en face d'une tôle ou d'une portion de tôle dont la surface est du même ordre de grandeur.

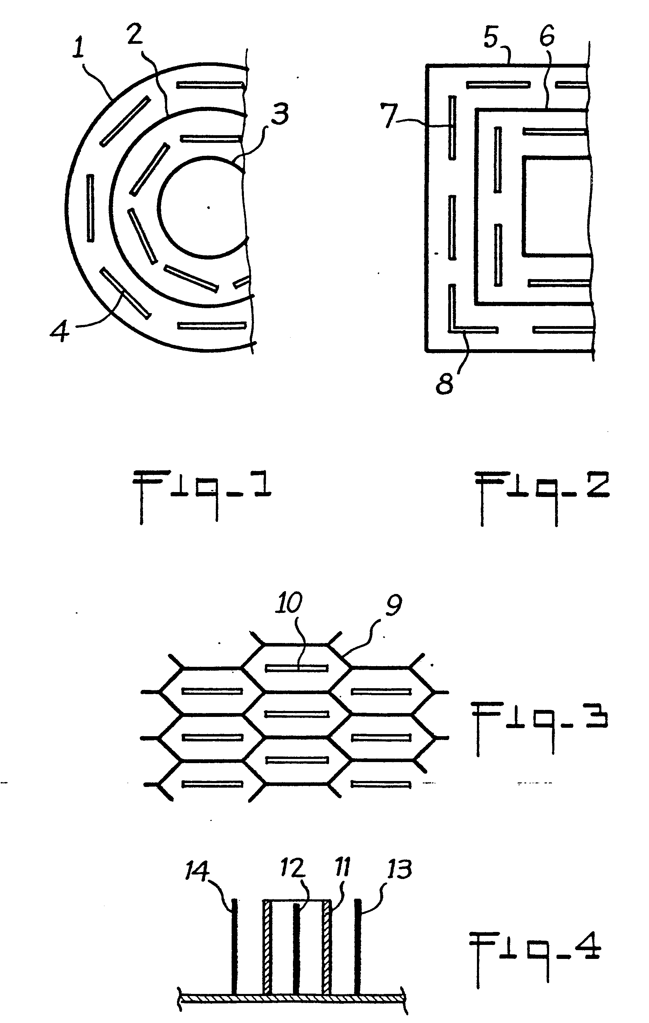

Des exemples de formes de tôles utilisables selon l'invention sont schématisés sur les figures 1, 2, 3 et 4.

La figure 1 montre en coupe transversale la disposition intérieure d'une enceinte. Sur cette coupe on a simplement représenté en (1), (2), et (3) trois tôles en un alliage riche en aluminium d'environ 1,5 mm d'épaisseur qui forment trois cylindres concentriques. Entre ces tôles on a disposé des pièces (4) à revêtir qui sont suspendues et dont la plus grande surface est avantageusement disposée de façon à faire face à deux desdites tôles. Bien évidemment l'invention n'est pas limitée à l'utilisation de trois tôles disposées concentriquement, on peut également employer soit deux tôles délimitant un seul espace soit plus généralement n tôles délimitant n-1 espaces dans lesquels les pièces à traiter sont introduites.

La figure 2 montre également en coupe transversale une autre disposition de tôles (5), (6) et de pièces (7) et (8); on remarquera que la pièce (8) à revêtir a une forme assez voisine de celle des tôles qui sont au voisinage de cette pièce.

La figure 3 montre une autre coupe transversale d'une portion de l'intérieur de l'enceinte dans laquelle les tôles (9) en matériau donneur ont une forme en nid d'abeille et entourent les pièces (10) à revêtir.

La figure 4 montre en coupe transversale un autre mode de réalisation de l'invention applicable par exemple pour réaliser le revêtement intérieur et extérieur d'une aube; cette aube schématisée en 11 est disposée autour d'une plaque donneuse 12 et sa face extérieure fait face à des plaques 13-14 convenablement disposées.

Comme on le voit dans les divers modes de réalisation de l'invention, les pièces à revêtir sont disposées dans l'enceinte de traitement de manière à faire face à une tôle jouant le rôle de donneur de l'élément métallique dont on veut enrichir la surface des pièces. On ajoute à la charge une faible quantité d'un sel halogéné, fluorure ou chlorure, on place l'enceinte, recouverte de son couvercle dans un four à atmosphère contrôlée, neutre ou réductrice et l'on chauffe le tout suivant un cycle thermique fonction de l'épaisseur du dépôt à effectuer, de la nature de l'alliage à revêtir ainsi que des éventuelles caractéristiques mécaniques à obtenir avec celui-ci.

La tôle constituant le donneur de l'élément destiné à enrichir la surface des pièces est attaquée par l'halogène issu de la décomposition du sel halogéné, produisant un halogénure de l'élément considéré, lequel se décompose au contact de la surface des pièces placées en regard de la tôle jouant le rôle de donneur, sans aucun contact avec celle-ci, et cet élément déposé à la surface des pièces y forme un alliage nouveau avec celui constituant les pièces en diffusant dans celles-ci grâce à la température à laquelle elles se trouvent portées.

L'halogène libéré par la décomposition de l'halogénure au contact des pièces attaque à nouveau la tôle "donneur" et le processus de transport vers la surface des pièces se poursuit de façon continue.

Le donneur utilisé peut être une simple tôle d'un alliage riche en aluminium si l'on veut obtenir un enrichissement superficiel de la pièce traitée en cet élément.

Conformément au principe de la présente invention, on peut substituer à la tôle "donneur" d'alliage riche en aluminium, une tôle en alliage différent, par exemple en alliage chrome-nickel dans le but cette fois d'obtenir un transfert de chrome à partir de cette nouvelle source vers la surface de pièces placées en regard, le nickel n'etant pas transféré en raison de la pression partielle d'halogénure de chrome nettement preponderante.

Dans ce cas, on obtiendra en surface des pièces un enrichissement en chrome, élément connu pour accroître de façon notable la tenue des pièces à la corrosion. Cette opération est désignée par l'appellation générale de "chromisation", laquelle est dans le cas de la présente invention réalisée strictement en "phase vapeur" sans contact solide entre la "source" (le donneur) et les pièces à protéger.

Ici encore, le procédé présente des avantages évidents de simplicité, de non-adhérence de produits divers sur les pièces, de limitation au strict minimum de la "source" entraînant une économie de chauffage et un maximum de souplesse des cycles thermiques.

On peut encore, selon la présente invention, choisir comme source une tôle en titane de pureté industrielle, type T.40 du commerce par exemple, que l'on place en regard des pièces que l'on désirerait enrichir superficiellement en titane, le tout dans une enceinte de traitement comme précédemment, en présence d'un sel halogéné, et obtenir à la surface desdites pièces, une couche d'alliage riche en titane à propriété spécifique de cet alliage.

Les exemples non limitatifs ci-après illustrent l'invention.

## Exemple 1

On place dans un récipient en tôle d'alliage résistant à chaud les éléments suivants: au centre, un barreau de l'alliage à revêtir qui sert à fabriquer les ailettes de turbomachines aéronautiques connu sous l'appellation commerciale IN.100 et dont la composition pondérale est la suivante:
Nickel: base, Cobalt: l5 %, Chrome: 10 %
Aluminium: 5,5 %, Titane: 4,5 %.

On place autour de ce barreau disposé verticalement des tôles constituées d'un alliage fer-aluminium à 25 % en poids d'aluminium, puis une faible quantité de fluorure d'ammonium anhydre en poudre. On ferme l'enceinte à l'aide d'un couvercle non étanche, puis on la place dans un four à atmosphère d'argon. Après avoir purgé convenablement l'enceinte et le four de l'air qu'ils contenient et avoir remplacé celui-ci par de l'argon, on procède au traitement thermique de l'enceinte avec son contenu à 1150°C durant 3 h, suivi d'un refroidissement relativement rapide. Après défournement, le barreau présente une couleur légèrement bleutée.

On a remarqué, au cours de l'essai, la montée rapide en température puis le refroidissement également rapide, après interruption du chauffage, par rapport à la solution qui consiste à utiliser une source donneuse d'aluminium en "pack" ou constituée de granules contenus dans des paniers métalliques. Ce résultat très intéressant est dû à la faible inertie thermique de la tôle, ou feuille mince d'alliage d'aluminium, utilisée comme "source". Sa simplicité d'emploi, par rapport aux anciennes solutions, est évidente et la place libérée, notamment par la suppression des paniers, pourra être utilisée pour augmenter le nombre de barreaux ou de pièces à traiter.

## Exemple 2

Dans cet exemple on a vérifié l'homogénéité du dépôt obtenu dans tout le volume de l'enceinte de traitement déjà utilisée dans l'exemple précédent, en remplaçant le barreau par un certain nombre de petits échantillons de masse préalable connue, régulièrement répartis dans l'espace utile de l'enceinte, à une distance pratiquement constante de la feuille d'alliage Fe-Al servant de source. Après un cycle de traitement identique on a constaté un gain de masse très voisin pour tous les échantillons, gain de masse que l'on avait pu relier par ailleurs à l'épaisseur du dépôt, grâce à des essais préalables. Cet essai montre donc la précision du dépôt qu'il est possible d'atteindre par l'emploi d'une "source" dont la position est bien définie par rapport aux pièces à revêtir.

## Exemple 3

L'utilisation d'éléments minces à grande surface développée pouvait à priori simplifier les tâches en production par rapport à des sources se présentant sous forme de granules en évitant d'avoir à les reconditionner entre chaque fournée de traitement, ce qui nécessite leur retrait de l'enceinte, le tamisage pour la vérification de leur granulométrie, la séparation des "fines", etc., et à nouveau leur répartition dans les différents paniers destinés à les recevoir. La répétition de plus de 10 fournées successives, sans démonter les feuilles minces servant de "sources", constituées d'alliage Fe-Al à 16 % d'aluminium, en changeant seulement les pièces à revêtir, a permis de vérifier, d'une part, la simplicité du procédé, d'autre part, le caractère répétitif et reproductible du résultat obtenu par la vérification des gains de poids obtenus.

## Exemple 4

La grande souplesse du procédé et ses possibilités variées ont été mises en évidence en changeant la nature de l'élément à déposer. Dans le but d'obtenir principalement une protection contre la corrosion dite "sulfurante", on a effectué un dépôt de chrome. A cet effet, on a utilisé une feuille mince d'alliage riche en chrome soit 50 % de cet élément et 50 % de nickel, disposée comme précédemment autour du barreau à revêtir dans une enceinte de traitement classique en présence d'un sel halogéné, en l'occurrence du chlorure d'ammonium, la charge ainsi constituée subissant ensuite un traitement de 5 h à 1100°C dans un four à atmosphère d'argon.

Après défournement, l'échantillon, de couleur blanc métallique uniforme, a révélé en coupe micrographique la présence d'un dépôt superficiel régulier de 30 à 35 μm d'épaisseur riche en chrome.

On constate la grande souplesse du procédé qui a permis, par simple changement dans la nature de la source, de déposer du chrome à la place de l'aluminium.

## Exemple 5

Dans le même esprit que l'exemple précédent, on a à nouveau changé la nature de la source en choisissant cette fois une feuille de titane du commerce (dénommée T.40) et avec des conditions de maintien à chaud différentes, à savoir 6 h environ à 850°C. Après défournement, l'echantillon présentait une couleur grise uniforme, et, après coupe micrographique, une couche de 6 à 8 μm d'épaisseur, parfaitement liée au métal de base et riche en titane.

## Exemple 6

Après les dépôts simples, soit de Al, soit de Cr, soit de Ti, obtenus simplement en changeant la nature de métal ou d'alliage constitutifs de la source en feuilles minces, sans changer le reste des dispositions, on a pu vérifier également que les dépôts multiples étaient possibles par addition de dépôts uniques. On a ainsi procédé, sur un barreau d'alliage IN.100, déjà cité dans le 1er exemple, à un premier dépôt de Cr, suivi d'un deuxième d'AL. Après défournement, l'échantillon présente une teinte blanc-gris. Son examen en coupe micrographique révèle un dépôt d'épaisseur totale de 70 μm, bien lié au métal de base, pouvant se subdiviser en trois zones d'aspect distinct. Des micrographies des dépôts obtenus montrent l'absence totale d'inclusions parasites dans le dépôt, grâce à l'emploi de sources en feuilles métalliques minces, à l'exclusion de tout produit granulaire ou pulvérulent.

Outre la réalisation de dépôts successifs de chrome et d'aluminium, on a pu réaliser également des dépôts successifs de Cr et de Ti, de Ti et de Al et même de trois dépôts successifs de Cr, de Ti et de Al.

Cette généralisation du procédé de dépôt en phase vapeur halogénée en une étape, d'un métal à partir d'une source à la réalisation de couches complexes en deux ou trois étapes, illustre bien le caractère de souplesse, de simplicité et de polyvalence du procédé, permettant ainsi de faire face à des agressions très variées, du type oxydation ou sulfuration, moyennant un changement minime dans le matériel utilisé.

## Revendications

1. Procédé, en phase vapeur, pour le dépôt d'au moins un revêtement protecteur sur une pièce métallique ou un ensemble de pièces, ledit revêtement étant à base d'aluminium, de chrome ou de titane d'un dérivé de ces métaux ou d'alliage ou mélanges de ces divers métaux, par réaction de la surface de ladite pièce métallique, convenablement chauffée dans une enceinte de traitement, avec un halogénure du métal à déposer formé par réaction, dans l'enceinte de traitement entre un composé chimique halogéné sur un donneur constituée par le métal à déposer ou un alliage à base du métal à déposer, éventuellement en présence d'un autre réactif chimique, le donneur et la pièce ou l'ensemble des pièces étant disposés sans contact solide, caractérisé en ce que ledit donneur se présente sous forme d'une tôle mince disposée de manière à ce que chacune des surfaces à revêtir soit en face d'une tôle ou d'une portion de tôle dont la surface est du même ordre de grandeur.

2. Procédé selon la revendication 1, caractérisé en ce que ladite tôle est disposée dans l'enceinte, sous forme de cylindres concentriques, entre lesquels la ou les pièces à revêtir sont disposées.

3. Procédé selon la revendication 1, caractérisé en ce que ladite tôle est formée d'un élément entourant latéralement la ou les pièces à revêtir.

4. Procédé selon la revendication 1, caractérisé en ce que ladite tôle mince est conçue de façon à pouvoir être introduite à l'intérieur d'une pièce de façon à réaliser le revêtement de la surface intérieure de ladite pièce.

## Patentansprüche

1. Verfahren zur aus der Dampfphase erfolgenden Abscheidung wenigstens eines auf Aluminium, Chrom oder Titan, einem Derivat dieser Metalle oder auf einer Legierung oder Mischungen dieser verschiedenen Metalle basierenden Schutzüberzugs auf einem Metallteil oder einer Anordnung von Metallteilen durch Reaktion der Oberfläche des in einem Behandlungsraum in geeigneter Weise erwärmten Metallteils mit einem Halogenid des abzuscheidenden Metalls, das gebildet ist durch in dem Behandlungsraum erfolgende Reaktion zwischen einer halogenisierten chemischen Verbindung auf einem aus dem abzuscheidenden Metall oder einer Legierung auf der Basis des abzuscheidenden Metalls bestehenden Donator, gegebenenfalls in Anwesenheit von einem weiteren chemischen Reagenz wobei der Donator und das Metallteil oder die Anordnung von Metallteilen ohne festen Kontakt angeordnet sind, dadurch gekennzeichnet, daß der Donator die Form eines dünnen Blechs hat, das derart angeordnet ist, daß jede der mit dem Überzug zu versehenden Flächen einem Blech oder einem Blechteil gegenüberliegt, dessen Fläche die gleiche Größenordnung hat.

2. Verfahren nach Anspruch 1, dadurch gekennzeichnet, daß das Blech in dem Behandlungsraum in Form konzentrischer Zylinder angeordnet ist, innerhalb derer das Teil oder die Teile, die mit dem Überzug zu versehen sind, angeordnet ist bzw. sind.

3. Verfahren nach Anspruch 1, dadurch gekennzeichnet, daß das Blech aus einem Element besteht, das das Teil oder die Teile, die mit dem Überzug zu versehen sind, seitlich umschließt.

4. Verfahren nach Anspruch 1, dadurch gekennzeichnet, daß das dünne Blech so konzipiert ist, daß es derart in das Innere eines Teils einführbar ist, daß sich auf der Innenfläche des Teil ein Überzug ausbilden läßt.

## Claims

1. Vapour phase process for depositing at least one protective coating on one or more metallic articles, the said coating being based on aluminium, chromium or titanium, a derivative of these metals or an alloy or mixtures of these various metals, by reaction of the surface of the said metallic article, suitably heated in a treatment chamber, with a halide of the metal to be deposited formed by reaction, in the treatment chamber, between a halogenated chemical compound and a donor constituted by the metal to be deposited or an alloy based on the metal to be deposited, possibly in the presence of another chemical reagent, the donor and the article or articles being disposed without contact therebetween, characterised in that the said donor takes the form of thin sheet metal arranged so that each of the surfaces to be coated is faced by sheet metal or a portion of sheet metal of which the surface is of the same order of magnitude.

2. Process according to claim 1, characterised in that the said sheet metal is disposed in the chamber in the form of coaxial cylinders, between which the article or articles to be coated are arranged.

3. Process according to claim 1, characterised in that the said sheet metal is formed as an element laterally surrounding the article or articles to be coated.

4. Process according to claim 1, characterised in that the said sheet metal is formed so as to be able to be introduced into the interior of an article in order to effect the coating on the inner surface of the article.

Fig-1

Fig-2

Fig-3

Fig-4